# EUROPEAN PATENT APPLICATION

(11) **EP 1 022 781 A1**
(43) Date of publication of application: **26.07.2000**
(21) Application number: 99929816.9
(22) Date of filing: 13.07.1999
(51) Int. Cl.: H01L 23/26

(54) **OPTICAL DEVICE, ELECTRONIC DEVICE ENCLOSURE, AND GETTER ASSEMBLY**

(30) Priority: 14.07.1998 JP 19853598
(71) Applicant: The Furukawa Electric Co., Ltd., Tokyo 100-8322 (JP)
(72) Inventor: AIKIYO, Takeshi, The Furukawa Electric Co., Ltd, Tokyo 100-8322 (JP); KIMURA, Toshio, The Furukawa Electric Co., Ltd, Tokyo 100-8322 (JP); IKEGAMI, Yoshikazu, The Furukawa Electric Co., Ltd, Tokyo 100-8322 (JP)
(74) Representative: Maury, Richard Philip
(86) International application number: JP9903779
(87) International publication number: WO0004580

(57) **Abstract**

A getter housing (10) is formed by using a metal fiber sintered sheet (16) having holes of a size allowing impurity gas etc. to pass through while not allowing a getter (18) to pass through in order to absorb or adsorb moisture, impurities, etc. by the getter (18). The metal fiber sintered sheet (16) is preferably stainless steel and the mean diameter of the holes is not more than 10 µm. A getter assembly comprised by the getter (18) and a getter housing (10) is housed in a package of an optical device/electronic circuit housing device housing an optical device including a semiconductor laser and an electronic circuit is used, for example, as an optical repeater.

## Description

### TECHNICAL FIELD

The present invention relates a getter assembly comprised of a getter for absorbing or adsorbing moisture, organic gas, etc. and a getter housing for housing the getter.

The present invention further relates to an optical device/electronic circuit housing device comprising an optical device including a semiconductor laser, an electronic circuit, and a getter assembly housed in a package filled with an inert gas or other gas, wherein a getter inside the getter assembly housed in the package absorbs or adsorbs moisture, organic gas, etc. inside the package so as to stabilize the operation of the optical device, electronic circuit, etc.

### BACKGROUND ART

Optical devices including semiconductor lasers and photodiodes and signal processing circuits and other electronic circuits are often used housed in packages in the fields of signal processing, optical communication, etc.

In an optical device/electronic circuit housing device housing such an optical device and electronic circuit in a package, it has been considered desirable to stabilize the operations of the semiconductor laser, electronic circuit, etc. and prolong their life by making the inside of the package inert. In particular, it has been considered desirable to make the inside the package a dry, inert atmosphere free from oxygen. As such an inert state, the inside of the package is made a dry nitrogen atmosphere containing, for example, a helium tracer.

In an optical device including a semiconductor laser, as the wavelength of the light which is output by pumping the semiconductor laser used as a light amplifier, two wavelengths, that is, a short wavelength band of 980 nm (0.98 µm) and a long wavelength of 1480 nm (1.48 µm) are normally used.

When using a semiconductor laser of a short wavelength of for example 980 nm, the phenomenon of PIF (packing induced failure) is known as one of causes for deterioration of the reliability of such a semiconductor laser. The "PIF phenomenon" is the phenomenon wherein hydrocarbons present in the package are broken down by a photochemical reaction due to the light from the semiconductor laser and deposits as a liquid or solid organic substance on the light emitting facet end of the semiconductor laser, the deposited organic substance is heated up by absorbing the light, thereby causing the facet of the semiconductor laser to be melt down and damaged. As a result, as pointed out in U.S. Patent No. 5,629,952 (Japanese Unexamined Patent Publication (Kokai) No. 7-147457), when using a semiconductor laser of a short wavelength band of 980 nm etc., the above PIF phenomenon occurs where the inside of the package is just made a dry helium/nitrogen atmosphere. Namely, in a dry helium/nitrogen atmosphere, the problems arise that contaminants inside the package deposit on a facet of the semiconductor laser, so the reflectivity increases and the output of the transmitted light is reduced and that the facet is heated and the absorption by the facet is increased causing a failure of the semiconductor laser. As the contaminants inside the package, there are particle and gaseous contaminants, solder-flux, oil, epoxy resins, cleaning agents, etc. reaching the surface of the facet coating when producing the semiconductor laser, contaminants generated and remaining at the time of packaging, reaction products generated by reaction between the hydrocarbons in the package and the light from the semiconductor laser, etc.

When the output of the semiconductor laser is increased, the reaction products generated by the reaction of the hydrocarbons in the package with the light of the semiconductor laser are increased, so when the output of the semiconductor laser increases, the problem of the above PIF phenomenon becomes greater.

U.S. Patent No. 5,629,952 proposes as a method of preventing occurrence of the PIF phenomenon the method of sealing the inside of the package with an inert gas such as nitrogen including at least 100 ppm of oxygen. The oxygen filled in the package acts as a reaction gas to bond with the hydrocarbons generated from an electronic circuit, optical device, etc. in the package to form water. Also, the oxygen filled in the package is believed to bond with the reaction product which is generated by the reaction between the organic impurity gas from the electronic circuit, optical device, etc. and the semiconductor laser light, thereby preventing the optical reaction product from precipitating on the facet mirror or to remove the reaction product precipitated on the facet mirror. Further, the filled oxygen is considered to function as a getter to directly absorb or adsorb the organic impurity gas comprising the above contaminant. Namely, according to the method disclosed in U.S. Patent No. 5,629,952, since the organic substance deposited on the facet of the semiconductor laser reacts with the oxygen to prevent accumulation of the organic substance on the facet of the semiconductor laser, it is considered possible to prevent the occurrence of PIF.

On the other hand, however, the oxygen filled inside the package reacts with the hydrogen unavoidably present inside the package to generate water.

The oxygen in the package reacts, for example, with the organic substance deposited on the facet of the semiconductor laser element to generate water in some cases. The water generated in this way may cause the same problem as above.

Attempts have also been made to use oxygen to avoid the reaction with hydrogen inside the package by preventing the presence of hydrogen in the package. For example, U.S. Patent No. 5,629,952 discloses a method for baking the package to reduce the hydrogen (or hydrocarbons) to a low level.

However, it is difficult to continue eliminating the hydrogen completely from the package. Hydrogen sometimes is present even after baking the package. U.S. Patent No. 5,696,785 (Japanese Unexamined Patent Publication (Kokai) No. 8-213678) states that when filling oxygen in a package, water is generated by the bonding of oxygen and hydrogen inside the package and that the water causes short-circuits, corrosion, electromigration, etc. in an electronic circuit inside the package.

U.S. Patent No. 5,629,952 proposes to house a getter for organic impurities in the package in addition to filling oxygen. As such a getter, porous silica, Na-Al-Si zeolite, etc. may be mentioned as examples.

To prevent short-circuits of the circuit portion of a semiconductor laser inside a package and other deterioration of the optical performance of the optical device and to prevent short-circuits in the electronic circuit inside the package due to condensation when using an optical device/electronic circuit housing device at a low temperature, the atmosphere inside the package is sealed by an inert gas such as nitrogen having a low dew point.

Further, when using a semiconductor laser of 980 nm wavelength band, moisture is generated due to the PIF phenomenon as explained above, so the problem arises of a rise of the dew point.

When using a semiconductor laser of other than the 980 nm band, for example, 1480 nm, since the above PIF phenomenon does not occur, there is no need to fill oxygen in the package and the package is hermetically sealed only with nitrogen. Accordingly, in this case, in principle, no water is generated due to a reaction of oxygen and hydrogen. However, even when using a semiconductor laser of other than the 980 nm band, for example 1480 nm, a rise of the dew point caused by the moisture released from parts housed in the package cannot be prevented over a long period of time. Further, when housing, for example, a Peltier module which is a sintered body of Bi and Te, in a package for the cooling of a semiconductor laser etc., the rise of the dew point of the atmosphere inside the package caused by the moisture released from the Peltier module becomes a problem in some cases.

The rise of the dew point makes it easier for moisture to be produced inside the package of the optical device/electronic circuit housing device. Such a rise of the dew point becomes an especially serious problem, for example, when using an optical device/electronic circuit housing device as a repeater in a submarine communication system which is especially difficult to maintain and inspect and for which replacement is difficult in the event of a breakdown.

U.S. Patent No. 5,696,785 discloses to house in a package a getter to immobilize the moisture and organic impurities in the package.

As such a getter, a material obtained by bonding an inorganic binder and consolidated porous body may be mentioned as an example. As the consolidated porous body, an example made of zeolite and porous silica may be mentioned. In U.S. Patent No. 5,696,785, a getter is housed in a getter housing (getter case) and fixed to a ceiling portion inside the package. As the getter housing, a porous metal having poromeric pores smaller than the getter size is used. The getter housing is attached to an inside wall of the package mechanically or by the method of soldering, laser welding, etc.

When housing in a getter housing a getter made by bonding an inorganic binder and a consolidated porous silica gel for absorbing or adsorbing moisture and organic impurity gas and arranging the same on the ceiling inside the package, the getter formed by the porous material is relatively fragile and breaks into fine powder (particles) due to deterioration by long term usage to cause particulate shedding off the getter housing. The shedded getter deposits on the optical device and electronic circuit placed thereunder and, as a result, failure, damage, or a deterioration of the properties sometimes occur.

EP Patent No. 720,260A1 (Japanese Unexamined Patent Publication (Kokai) No. 8-236660) discloses to house a getter in a getter housing (getter case) made by a porous metal and to house the getter housing in a package so as to prevent such trouble. Such a getter housing made by a porous metal is a metal case formed by pressing or electrodischarge machining or a metal case wherein through holes are formed by water-jet processing or laser processing.

EP Patent No. 720,260A1 describes that holes or through holes in the porous metal in such a getter housing are of sizes which is permeable to moisture and organic impurity gas, but block the passage of powder-like getter, but does not give any specific numerical values for to sizes of such holes.

In the method disclosed in EP Patent No. 720,260A1, since such holes or through holes in the porous metal are formed by pressing, electrodischarge machining, water-jet processing, or laser processing, it is difficult to make the diameters of the holes smaller than a certain extent. As a result, getter powder (particles) inside the getter housing becoming fine due to deterioration due to long term usage of the optical device/electronic circuit housing device passes through the holes and moves close to the semiconductor laser, electronic circuit, etc. to cause electrical short-circuits and form obstacles on a light path in the optical device including a semiconductor laser, therefore there is a possibility of causing a failure of the optical device/electronic circuit housing device and a deterioration of the properties such as an increase of the reflectivity.

Also, the porous metal used for the getter housing is high in price.

Further, when using a porous metal as the getter housing, since thin sheet work is difficult, the thickness of the getter housing becomes larger and the getter housing becomes larger. Thus, it is difficult to make the optical device/electronic circuit housing device compact. Since optical device/electronic circuit housing devices are sometimes used as, for example, repeaters in a submarine optical communication system where maintenance, inspection, and replacement are difficult, there is a strong demand for realizing a highly reliable compact optical device/electronic circuit housing device.

### DISCLOSURE OF INVENTION

An object of the present invention is to provide a getter assembly comprising a getter for absorbing or adsorbing impurities and a getter housing for housing the getter and having holes of a size through which impurities can pass and the getter is not released to the outside so that the housed getter absorbs or adsorbs the impurities.

Another object of the present invention is to provide a compact and low cost optical device/electronic circuit housing device which houses an optical device including a semiconductor laser, an electronic circuit, and a getter assembly in a package and absorbs or adsorbs impurities inside the package by the getter inside the getter assembly, wherein the getter inside the getter assembly is not shed in the package over a long term.

Still another object of the present invention is to provide a low cost optical device/electronic circuit housing device of a high reliability capable of operating stably for a long time even under a circumstance where condensation easily occurs.

A getter assembly of the present invention comprises a getter for absorbing or adsorbing impurities and a getter housing for housing the getter which is at least partially comprised by a metal fiber sintered sheet having a plurality of holes which allow the impurities to pass through and do not allow the getter to pass through.

The metal fiber sintered sheet is produced for example by pressing a slurry containing fibers made of stainless steel and binder fibers to remove the moisture, then drying the same under heat to fabricate a high metal fiber sheet, then sintering the high metal fiber sheet.

Preferably, the average diameter of the plurality of holes formed in the metal fiber sintered sheet is not more than 15 µm, preferably not more than 10 µm. Note that the holes are not a perfect circles, but are circularly shaped, so even though using the term "diameter", it refers to the diameter in the sense of the average of a circular shape.

When referring to "impurities" in the present invention, it means everything which has a detrimental effect on the operations of the optical device etc. of the optical device/electronic circuit housing device and causes a failure. The "impurities" in the present invention include, for example, an organic impurity gas, moisture, etc.

In the above getter assembly, preferably the metal fiber sintered sheet is made of stainless steel and the stainless steel fiber sintered sheet is fixed to a fixing portion of the getter housing by seam welding, soldering, laser welding, etc.

The getter comprises any one of silica gel, a zeolite-based hygroscopic agent/adsorbent (zeolite or molecular sieve (product name of Linde Co.)), and a mixture of silica gel and a zeolite-based adsorbent.

An optical device/electronic circuit housing device of the present invention comprises a package. an optical device including a semiconductor laser housed in the package, an electronic circuit housed in the package, a gas including an inert gas filled in the package, and a getter assembly provided in the package. The getter assembly comprises a getter for absorbing or adsorbing impurities which may exist in the package and a getter housing at least partially composed of a metal fiber sintered sheet having a plurality of holes which allow the impurities to pass through and do not allow the getter to pass through.

The gas filled in the package comprises only an inert gas or an inert gas including oxygen. For example, an optical device/electronic circuit housing device, when using a semiconductor laser of a short wavelength band such as 980 nm, has an inert gas including oxygen filled in the package as a PIF countermeasure, while when using a semiconductor laser of a long wavelength band such as 1480 nm, has only an inert gas filled.

Alternatively, an optical device/electronic circuit housing device of the present invention comprises a package, an optical device including a semiconductor laser housed in the package, an electronic circuit housed in the package, and a gas containing an inert gas filled in the package, wherein a portion for housing a getter for absorbing or adsorbing impurities is provided on the inner wall of the package, the getter is housed in the getter housing portion, and at least a part of the getter housing portion housing the getter is comprised by a metal fiber sintered sheet having a plurality of holes which allow the impurities to pass through and do not allow the getter to pass.

Further, alternatively, a housing device of the present invention comprises a package, a gas containing an inert gas filled in the package, and a getter assembly provided in the package or on a part of the package, wherein the getter assembly comprises a housing for housing the getter for absorbing or adsorbing impurities, and the housing is at least partially composed by a metal fiber sintered sheet having a plurality of holes which allow the impurities to pass through and do not allow the getter to pass through.

The above objects and features of the present invention will become clearer by the following description given with reference to the accompanying drawings.

### BRIEF DESCRIPTION OF DRAWINGS

Figure 1 is a plane view of a 14-pin butterfly package as an example of an optical device/electronic circuit housing device of the present invention.
Figure 2A is a sectional view of a main portion of the optical device/electronic circuit housing device along the line A-A in Fig. 1, and Fig. 2B is a sectional view along the line B-B in Fig. 2.
Figure 3 is a perspective view of a getter housing of the present embodiment.
Figure 4 is a plane view of the getter housing illustrated in Fig. 3 before housing the getter in the getter housing.
Figure 5 is a sectional view of the getter housing along the line C-C after housing the getter in the getter housing.
Figure 6 is a view of another example of providing a getter assembly inside the package of the optical device/electronic circuit housing device.
Figure 7A is a plane view of the getter assembly before fixing a metal fiber sintered sheet according to a second embodiment of a getter assembly of the present invention, Fig. 7B is a plane view of the getter assembly after fixing the metal fiber sintered sheet, Fig. 7C is a sectional view along the line AA-AA in Fig. 7B, and Fig. 7D is a sectional view along the line BB-BB in Fig. 7B.
Figure 8 is a partial view of an optical device/electronic circuit housing device housing a getter according to another embodiment of the optical device/electronic circuit housing device of the present invention with a package and a metal fiber sintered sheet.

### BEST MODE FOR CARRYING OUT THE INVENTION

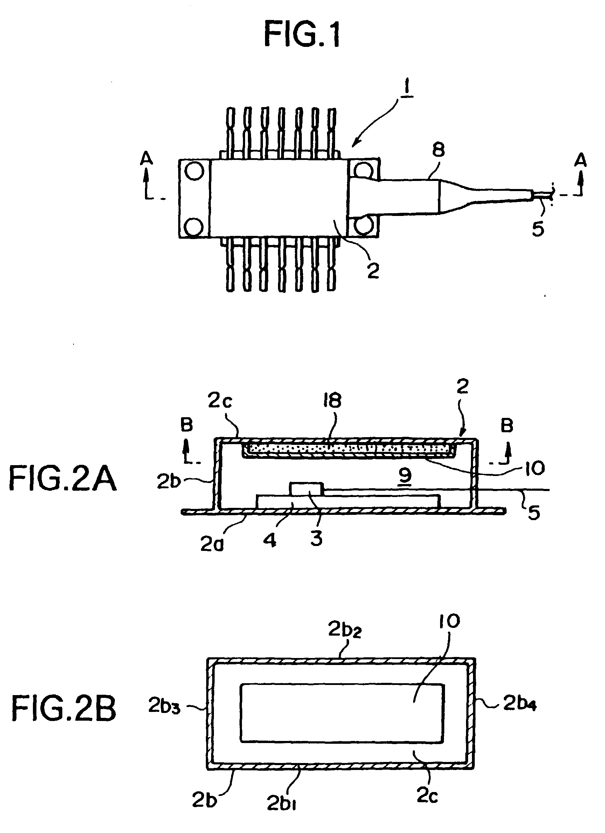

Figure 1 is a plane view from the outside of an optical device/electronic circuit housing device according to an embodiment of an optical device/electronic circuit housing device of the present invention.

An optical device/electronic circuit housing device 1 of the present embodiment is a 14-pin butterfly package with a package 2 and 14 pins projecting on the two sides of the package 2. Inside the package 2 is housed a not illustrated optical device including a semiconductor laser and an electronic circuit. An optical fiber 5 is fit in the optical device/electronic circuit housing device 1 via a hermetically sealed fixing portion 8 in order to connect the optical device and an external optical circuit. The 14 pins are used for passing a signal between the electronic circuit inside the package 2 and an external electronic circuit, supplying power, etc.

Figure 2A is an internal sectional view of a main portion of the optical device/electronic circuit housing device 1 illustrated in Fig. 1, and Fig. 2B is a plane view of the optical device/electronic circuit housing device 1 along the line B-B in Fig. 2A.

The optical device/electronic circuit housing device 1 is used, for example, for a signal processor in a variety of communication systems and an optical communication system of a repeater of a submarine cable etc.

The optical device/electronic circuit housing device 1 has a package 2 comprised by a base 2a, side walls (frame) 2b, and an upper cover 2c defining a sealed space 9. Namely, the package 2 is configured by the bottom portion 2a on which a substrate 4 is mounted, the upper cover 2c facing the bottom portion 2a for fixing a getter housing 6, and the side walls 2b for connecting the bottom portion 2a and the upper cover 2c. The side walls 2b are integrally formed by long metal side walls 2b1, 2b2 and short metal side walls 2b3, 2b4 for example by MIM (metal injection molding). The lengths of the side wall 2b1 and the side wall 2b2 are the same and the lengths of the side wall 2b3 and the side wall 2b4 are the same.

The optical device/electronic circuit housing device 1 further comprises a substrate 4, a semiconductor laser 3 installed on the substrate 4, and a getter housing 10 all housed in the package 2. On the substrate 4 are provided, other than the semiconductor laser 3, a lens or other optical device, a photodiode, and a signal processing circuit or other electronic circuit, which are not illustrated.

The inside the package 2 is made a dry state filled with an inert gas. The gas to be filled in the package 2 will be explained later.

At the side wall 2b of the package 2, an optical fiber 5 is introduced from the outside to inside the package via the fixing portion 8. As the optical fiber 5, there are an optical fiber for guiding an optical signal from the outside of the package 2 to a not shown opto-electronic inside the package 2, such as a photodiode, an optical fiber for leading to the outside of the package 2 the light obtained by amplifying the light received by the photodiode by an electronic circuit, performing a predetermined signal processing, and then driving the semiconductor laser 3 to emit light.

In the example shown in Fig. 2A and Fig. 2B, a getter housing 10 is fixed to the internal ceiling of the upper cover 2c of the package 2. A getter 18 is housed in the getter housing 10.

A method of producing the optical device/electronic circuit housing device 1 will be explained next.

The getter housing 10, package 2, and optical device and electronic circuit housed in the package 2 used are ones which do not contain impurities, organic substances which could become impurities in the future, etc. as much as possible. Especially, it is preferable to use materials which generates less products by a photoreaction with the light output from the semiconductor laser 3. Further, as the material, materials, preferably materials or states which do not contain hydrogen and have a low possibility of generating hydrogen in the future are preferable. An example of such conditions will be explained below.

An example of the process for production of the package 2 will be explained next.
(1) A bottom portion 2a comprised by Fe-Ni alloy, Fe-Ni-Co alloy, or other metals and side walls 2b integrally formed by long metal side walls 2b₁ and 2b₂ and short metal side walls 2b₃ and 2b₄ are prepared.
(2) The side wall 2b formed integrally with the metal bottom portion 2a is blazed. Also, the getter housing 10 is fixed to the metal upper cover 2c.
(3) The substrate 4 on which an optical device such as a semiconductor laser 3 and an electronic circuit are mounted is fixed on the metal bottom portion 2a.
(4) The metal upper cover 2c is seam-welded on the side wall 2b fixed on the metal bottom portion 2a. Seam welding is performed in a chamber which is adjusted to have a desired atmosphere (for example, a nitrogen atmosphere containing oxygen when the semiconductor laser 3 has a wavelength of 980 nm, and a nitrogen atmosphere which does not contain oxygen when the semiconductor laser 3 has a wavelength of 1480 nm) as a sealing gas atmosphere inside the package 2. When performing seam welding under such work conditions, components of the gas inside the package 2 can be controlled.

As the inert gas sealed in the package 2, nitrogen, helium, argon, etc. can be used. In the present invention, it is essential that the atmosphere inside the package contain an inert gas and is in a dry state. Oxygen may be contained as the filling gas inside the package 2, however oxygen is not always required to be contained. For example, a material which absorbs moisture may be used as the getter 18, and an inert gas, for example, only nitrogen may be filled as the filling gas in the package 2.

Specific examples of gases filled in the package 2 will be explained. When using a semiconductor laser 3 of a short wavelength such as a wavelength of 980 nm, for example, nitrogen containing 20% oxygen is filled in the package 2.

On the other hand, when using a semiconductor laser of a long wavelength such as a wavelength of the 1480 nm band, it is preferable not to fill oxygen in the package 2 and to fill an inert gas to prevent condensation, for example, only nitrogen having a low dew point, as a PIF countermeasure. The latter is preferable when using the optical device/electronic circuit housing device 1 in an environment where maintaining conditions resistant to condensation over a long period of time is desired, for example, using it as a repeater of a submarine communication system. Further, when using a semiconductor laser 3 of a long wavelength band other than the 980 nm band, such as a wavelength of 1480 nm, it is preferable to house in the package 2 a Peltier module made by a sintered body of Bi and Te in order to cool the semiconductor laser 3. In that case, however, it is preferable to use an inert gas of, for example, only nitrogen having a low dew point in addition to using the getter 18 for absorbing moisture released from the Peltier module. As explained above, the gas to be filled in the package 2 is appropriately selected in accordance with the conditions and usage.

A getter assembly comprised of the getter 18 and the getter housing 10 will be explained next.

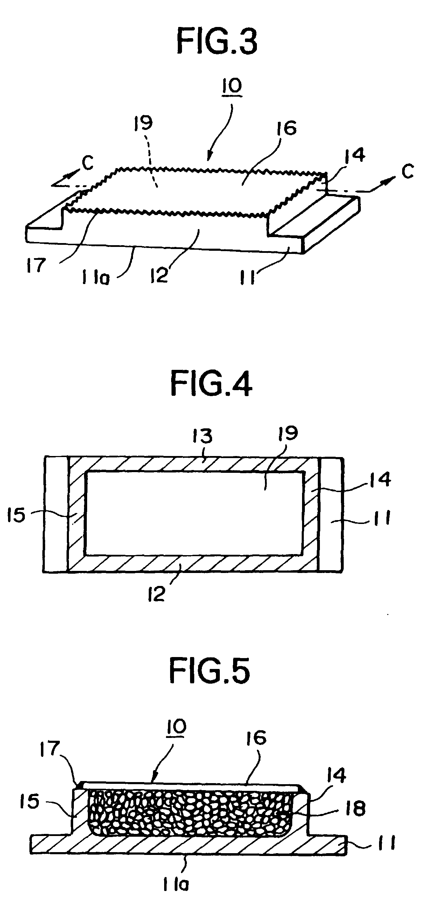

Figure 3 is a perspective view of a getter housing 10 according to the present embodiment.

Figure 4 is a plane view of the getter housing 10 illustrated in Fig. 3 before housing the getter 18 in the getter housing 10.

Figure 5 is a sectional view of the getter housing along the line C-C in Fig. 3 after housing the getter 18 in the getter housing 10.

In Figs. 3 to 5, the getter housing 10 comprises a base 11 fixed to a metal upper cover 2c comprising the package 2 in Fig. 2A, four sides 12, 13, 14 and 15 fixed in an upright state on the base 11, and a metal fiber sintered sheet 16 provided facing the base 11. A recess 19 is defined between the base 11, sides 12, 13, 14, and 15, and the metal fiber sintered sheet 16.

The base 11 and sides 12, 13, 14, and 15 are preferably formed as one piece. Of course, the base 11 and sides 12, 13 14, and 15 may be separately produced and joined by blazing, YAG laser spot welding, etc.

The getter 18 is filled in the recess 19.

After filling the getter 18 in the recess 19, the metal fiber sintered sheet 16 produced in advance is, for example, seam welded at a welding portion 17 on the upper surface of the sides 12, 13, 14, and 15 to seal the getter 18 in the recess 19, whereby a getter assembly comprised by the getter 18 and the getter housing 10 housing the getter 18 is completed.

The getter housing 10 illustrated in Figs. 3 to 5 is turned upside down from the state illustrated in Figs. 3 to 5 when the base 11 is fixed to the upper cover 2c of the package 2 in the state illustrated in Fig. 2A. Namely, a surface 11a of the base 11 is fixed to the upper cover 2c of the package 2. Accordingly, as illustrated in Fig. 2A, when the base 11 is fixed to the metal upper cover 2c of the package 2 in the getter assembly, the metal fiber sintered sheet 16 faces the metal bottom portion (metal base) 2a.

The metal fiber sintered sheet 16 produced in advance is a gas permeable porous metal fiber sintered sheet formed by sintering metal fiber and is configured to have a large number of very small through holes permeable to moisture and organic impurity gas but do not allowing the passage of fine getter particles. As a result, the getter housing 10 prevents the fine particles of getter 18 from being released over a long period of time.

The mean diameter of the through holes of the metal fiber sintered sheet 16 is not more than 15 µm, preferably not more than 10 µm. In a case of such a hole size, almost no getter is released from the getter housing. Note that the holes are not perfect circles, but are substantially circularly shaped holes, so the diameter means a rough diameter when regarding them as circles.

The getter 18 housed in the getter housing 10 is selected in accordance with the object to be absorbed or adsorbed existing in the package 2. A variety of getters can be used such as silica gel in a particle state or in a powder state, zeolite or similar substances, and glauconite or other forms of zeolite, porous silica sintered by an inorganic binder, a mixture of a zeolite-based hygroscopic agent/adsorbent and silica gel, etc. As a zeolite-based adsorbent, for example, a synthetic zeolite adsorbent produced by Linde Co. (product name: Molecular Sieves) heated and dehydrated can be used. A substance obtained by mixing silica gel and a zeolite-based adsorbent in a ratio of 1:1 is sold by Fuji Silicia.

A synthetic zeolite-based absorbent contains small pores of a uniform size. Gas and moisture are adsorbed in the pores. Such a synthetic zeolite absorbent especially excels in the ability of adsorbing moisture in a low dew point region. Silica gel has an ability of adsorbing an organic gas as well. When mixing silica gel and a zeolite-based absorbent for use as a getter, both an organic gas and moisture can be adsorbed. Note that an organic gas is one factor causing PIF, so when adsorbing and removing an organic gas by a getter containing silica gel, there is also the effect of suppressing the occurrence of the PIF itself.

A specific example of the metal fiber sintered sheet 16 will be explained below.

The metal fiber sintered sheet 16 can be produced from stainless steel, aluminum, titanium, etc., but is preferably produced from stainless steel in terms of long-term corrosion resistance, heat resistence, strength, weldability, and other properties and economy.

As the diameter of the gas permeable holes of the metal fiber sintered sheet 16, the smaller the diameter while still capable of allowing impurity gas to pass through, the better, however in terms of the facility of production, gas permeability, and economy, the mean diameter is not more than 15 µm, preferably not more than 10 µm in practical use.

The thickness of the metal fiber sintered sheet 16 is not limited, but preferably is about 80 to 120 µm. For example, when using a metal fiber sintered sheet 16 having a thickness of 100 µm and a mean hole diameter of 10 µm, sufficient gas permeability can be secured and the getter assembly can be made compact.

As explained above, the metal fiber sintered sheet 16 is thin, light in weight, and low in cost. Accordingly, by using such a metal fiber sintered sheet 16, the getter housing 10 can be made compact. As a result, the optical device/electronic circuit housing device 1 using the getter housing 10 can be made low in cost and compact.

A process of production will be explained for a case where the metal fiber sintered sheet 16 is a stainless steel metal fiber sintered sheet.

For example, a slurry containing stainless steel fiber having a fiber length of 4 mm and a fiber diameter of 8 µm and binder fiber is pressed to squeeze out the water by for example a wet papermaking method, the pressed substance is dried by heating to prepare a high metal fiber sheet, and the high metal fiber sheet is sintered at about 1200°C to produce a metal fiber sintered sheet 16. The sintering has the effects of reducing entrainment of impurity gas and hydrogen in the metal fiber sintered sheet 16 as much as possible in addition to producing a metal fiber sintered sheet having pores.

The price of the metal fiber sintered sheet 16 produced in this way is much lower in price than the porous metal disclosed in EU Patent No. 720,260A1. That is, the metal fiber sintered sheet of the present embodiment can be produced at a low cost and reduces the price of the getter housing 10. As a result, an optical device/electronic circuit housing device 1 using the getter housing 10 can be produced at a low cost.

The metal fiber sintered sheet 16 and the getter housing 10 are fastened by mechanical connection or welding or other metal Joining, but preferably the metals are joined by any one of seam welding, blazing, YAG laser spot welding, etc. which enable easy fabrication and reliable connection.

The base 11 and sides 12, 13, 14, and 15 formed as one piece separate from the metal fiber sintered sheet 16 comprising the getter housing 10 are preferably made by an Fe-Ni alloy, Fe-Ni-Co alloy, or other metal in the same way as the metal base 2a, metal side wall 2b, and metal upper cover 2c comprising the package 2 in terms of the above fixing means, small difference in the coefficients of expansion, etc.

The getter assembly comprised by the getter 18 and the getter housing 10 for housing the getter 18 is preferably provided at each portion in the package 2 in order to promote absorption or adsorption of moisture and organic impurity gas. However, in terms of making the optical device/electronic circuit housing device 1 compact and low in price, the least possible number of getter assemblies are housed in the package 2.

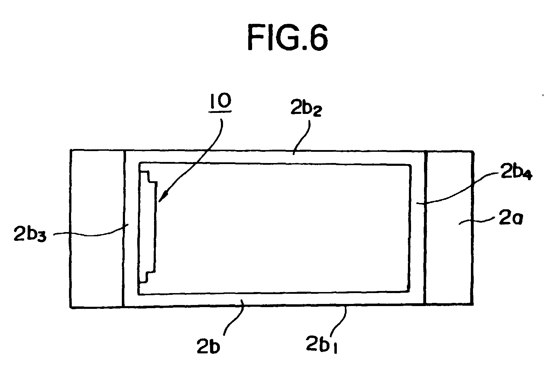

The example shown in Fig. 2A is an example of fixing the getter housing 10 (getter assembly) on the internal ceiling portion of the package 2. From the viewpoint of permeability to moisture and organic impurity gas to inside the getter housing 10, normally, as an example shown in Fig. 2A, it is sufficient that the getter housing 10 be provided at least at one portion inside the package 2 in the same way as fixing the getter housing 10 to the metal upper cover 2c of the package 2. Of course, as illustrated in Fig. 6, it may be fixed on the other side of the side wall (frame) 2b₃ of the package 2. Figure 6 is a plane view when the getter assembly is fixed on the metal side wall 2b inside the package 2.

When moisture is generated in the package 2 such as when promoting the cooling of the semiconductor laser 3 by inserting a sintered body of bismuth (Bi) and tellurium (Te), that is, a Peltier module, in the package 2, the getter housing 10 may be provided on the base 2a in Fig. 2A or close to the portion where the Peltier module is arranged.

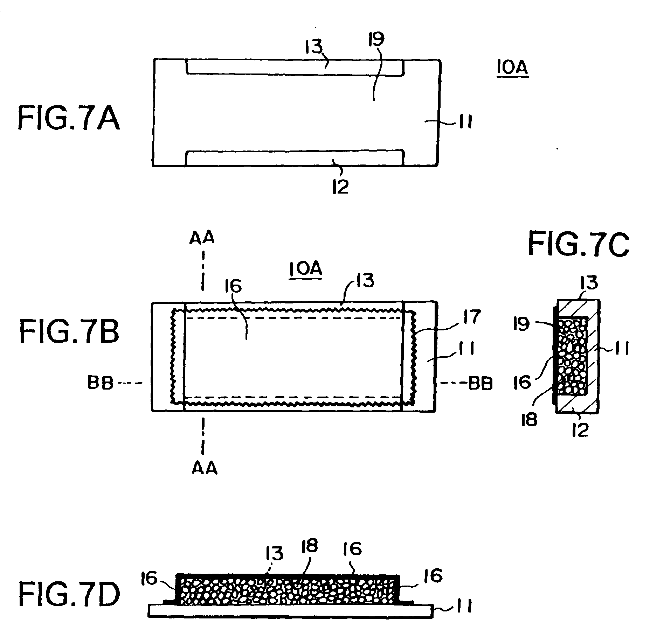

A second embodiment of the getter housing of the present invention will be explained next with reference to Figs. 7A to 7D.

Figure 7A is a plane view of a getter housing 10A before fixing the metal fiber sintered sheet 16 according to the second embodiment, Fig. 7B is a plane view of the getter housing 10A after fixing the metal fiber sintered sheet 16, Fig. 7C is a sectional view along the line AA-AA in Fig. 7B, and Fig. 7D is a sectional view along the line BB-BB in Fig. 7B.

The getter housing 10A comprises a base 11 and sides 12 and 13. Namely, the getter housing 10A illustrated in Fig. 7A does not have the sides 14 and 15 in the getter housing 10 illustrated in Fig. 4. It is the same as the above getter housing 10 in the point that the base 11 and the sides 12 and 13 are formed as one piece and are therefore the same in material.

In the getter housing 10A, after the getter 18 is filled in the recess 19, the metal fiber sintered sheet 16 is bridged to the position extending to the base 11 from the portion above the sides 12 and 13 through the side portions of the sides 12 and 13 and fixed to the base 11 and sides 12 and 13 formed as one piece. The fixing means is the same as in the above and is for example YAG laser spot welding.

In this way, the metal fiber sintered sheet 16 occupies one portion of the getter housing. It is sufficient if the getter 18 inside the getter housing 10A and impurities outside the getter housing (inside the package 2) are in a state where they can contact. Of course, if there are many holes in the metal fiber sintered sheet 16, the contact between the getter 18 and the impurities increases, therefore it is preferable that the metal fiber sintered sheet 16 be as wide as possible.

As the getter 18 filled in the recess 19 of the getter housing 10A, in the same way as in the above, use may be made of silica gel, zeolite, and porous silica sintered by an inorganic binder or a mixture of silica gel and a zeolite-based adsorbent.

The method of fixing the optical device/electronic circuit housing device 1 of the getter assembly, wherein the getter 18 is housed in the getter housing 10A, to the inside of the package 2 is the same as the above explained method.

In the above embodiment, as the optical device/electronic circuit housing device 1, a case of producing a getter assembly housing the getter 18 in the getter housing 10 or 10A and housing that getter assembly inside the package 2 was explained as an example. Namely, in the above embodiment, a case where the getter housing 10 or 10A and the package 2 were separately produced was explained, however, the optical device/electronic circuit housing device 1 may be configured with the package 2 formed as a getter housing the getter 18.

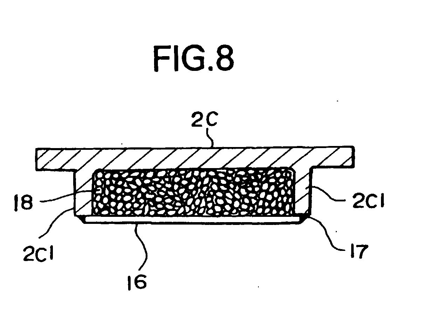

For example, it is possible to directly house the getter 18 by the package 2 and the metal fiber sintered sheet 16 by making the upper cover 2c portion of the package 2 shown in Fig. 2A as illustrated in Fig. 8. Figure 8 is a partial view of the package showing as an example the housing means of the getter 18.

In Fig. 8, a metal surrounding wall 2c₁ is provided on the metal upper cover 2c illustrated in Fig. 2A. Preferably, the metal upper cover 2c and the metal surrounding wall 2c₁ are formed in one piece. The getter 18 is filled in the recess defined by the metal upper cover 2c and the surrounding wall 2c₁. Of course when filling the getter 18, the metal upper cover 2c is turned upside down from the illustration. In this state, the metal fiber sintered sheet 16 is arranged above the surrounding wall 2c₁ and the metal fiber sintered sheet 16 is fixed to the surrounding wall 2c₁ at the welding portion 17 in the same way as in the above.

In this way, a package is formed by combining the metal upper cover 2c having the getter 18 housed between the metal surrounding wall 2c₁, the metal upper cover 2c, and the metal fiber sintered sheet 16 with the metal bottom portion 2a and metal side wall 2b illustrated in Figs. 3 to 5. Note that the package comprises the getter 18 and the metal fiber sintered sheet 16. The getter 18 and the metal fiber sintered sheet 16 in this case function in the same way as in the above.

The method of joining the getter 18 and the metal fiber sintered sheet 16 with the package is not limited to the metal upper cover 2c. The getter 18 and the metal fiber sintered sheet 16 may be formed integrally with the metal bottom portion 2a and the metal side wall 2b.

### Examples

A getter housing 10 made by Fe-Ni alloy as shown in Fig. 5 and a getter housing as shown in Fig. 3 and Fig. 4 prepared by filling in as the getter 18 particles of silica gel having a particle size of not less than 100 µm and covering this with a metal fiber sintered sheet 16 made by stainless steel to fix them together was produced. The seam welding method was used for fixing at this time.

The metal fiber sintered sheet 16 made by stainless steel used had a thickness of 85 µm and dimensions of a plurality of holes having a maximum diameter of 12 µm, a mean diameter of 8 µm, and a porosity of 80%.

The porosity is defined as the ratio of the volume of the empty portion with no metal fiber to the apparent volume (for example, in a case of a parallopiped, the product of the length, width, and thickness).

Since the holes in the metal fiber sintered sheet 16 are in the range of 12 µm to 8 µm as compared with a getter 18 comprised of particles of silica gel having a particle size of not less than 100 µm, even if the getter 18 is made finer, it is not released from the getter housing 10.

The getter assembly produced in this way is fixed to an internal side of the side wall 2b3 of the metal package 2 comprised of the metal base 2a, metal side wall 2b, and metal upper cover 2c as shown in Fig. 6. The method of fixing used was YAG laser spot welding. As other fixing methods, inorganic materials such as glass, low melting point metals, etc. can be used.

The members used for the metal package 2 are all comprised of Fe-Ni-Co alloy. An optical device including a semiconductor laser 3 and an electronic circuit are housed in such a metal package 2, nitrogen gas including 20% oxygen is filled therein, and a metal cover 2c is placed on the frame 2b and hermetically sealed by seam welding.

The optical device/electronic circuit housing device 1 produced in this way was continuously operated for 8000 hours. At the end of the test, the concentration of the water in the atmosphere inside the package 2 was less than 5000 ppm. Also, during the above period, the getter was not released from the getter housing and the device was confirmed to operate as the optical device/electronic circuit housing device 1 without any trouble.

According to the present invention, by configuring a getter assembly by a getter for absorbing or adsorbing an impurity gas and a getter housing for housing the getter comprising a metal fiber sintered sheet having gas permeability by small holes allowing an impurity gas to pass through while not allowing the getter to pass through, it is possible to prevent the getter from being released and the functions of the getter can be maintained for a long period of time. A getter assembly of the present invention can be produced to be compact, light in weight, and low in cost.

Further, according to the present invention, by using the above getter assembly, it becomes possible to maintain the inside of the package of the optical device/electronic circuit housing device housing the optical device and electronic circuit in a predetermined condition over a long period of time and to use the optical device/electronic circuit housing device stably over a long period of time.

### INDUSTRIAL APPLICABILITY

An optical device/electronic circuit housing device of the present invention can be used as an optical device/electronic circuit housing device having a semiconductor laser built therein. The optical device/electronic circuit housing device of the present invention can be used as, first, a repeater for optical communication and an opto-electronic apparatus in a variety of other fields. The optical device/electronic circuit housing device of the present invention especially excels in use for components requiring high reliability such as a repeater in a submarine optical communication system where replacement is difficult.

The getter assembly of the present invention can be widely used for, first, the above optical device/electronic circuit housing device and, also, other apparatuses requiring absorption or adsorption of an organic impurity gas etc.

### LIST OF REFERENCES

- 1: optical device/electronic circuit housing device
- 2: package
- 2a: base
- 2b: side walls
- 2c: upper cover
- 3: semiconductor laser
- 4: substrate
- 5: cable
- 8: connector
- 9: sealed space
- 10: getter housing
- 11: base
- 12, 13, 14, 15: sides
- 16: metal fiber sintered sheet
- 17: welding portion
- 18: getter

## Claims

1. A getter assembly comprising:
a getter (18) for absorbing or adsorbing impurities and
a getter housing (10) for housing the getter and at least partially comprised by a metal fiber sintered sheet (16) having a plurality of holes which allow said impurities to pass through while not allowing the getter to pass through.

2. A getter assembly as set forth in claim 1, wherein said impurities include moisture and/or organic impurities; and
wherein said getter absorbs or adsorbs said moisture and/or organic impurities.

3. A getter assembly as set forth in claim 1 or 2, wherein said getter contains any of porous silica gel, a zeolite-based hygroscopic agent/adsorbent, and a mixture of silica gel and a zeolite-based hygroscopic agent/adsorbent.

4. A getter assembly as set forth in any one of claims 1 to 3, wherein said metal fiber sintered sheet has a plurality of holes of a mean diameter of not more than 10 µm.

5. A getter assembly as set forth in any one of claims 1 to 4, wherein said metal fiber sintered sheet (16) is made by stainless steel.

6. A getter assembly as set forth in claim 5, wherein said metal fiber sintered sheet (16) is produced by
pressing a slurry containing stainless steel fiber and binder fiber to remove the water;
preparing a high metal fiber sheet by drying by heating the pressed substance; and
sintering the high metal fiber sheet.

7. A getter assembly as set forth in any one of claims 1 to 6, wherein portions other than said metal fiber sintered sheet (16) of said getter housing (10) is formed by Fe-Ni-Co alloy etc., and
wherein said metal fiber sintered sheet (16) is fixed to said getter housing.

8. An optical device/electronic circuit housing device, comprising:
a package (2);
a semiconductor laser (3) housed in the package;
a gas containing an inert gas filled in the package; and
a getter assembly provided in said package,
wherein said getter assembly comprises a getter for absorbing or adsorbing impurities and a getter housing (10) for housing the getter and at least partially comprised by a metal fiber sintered sheet (16) having a plurality of holes which allow said impurities to pass through while do not allow the getter to pass through.

9. An optical device/electronic circuit housing device, comprising:
a package (2);
an optical device including a semiconductor laser (3) housed in the package; and
a gas containing an inert gas filled in the package;
wherein an inner wall of said package has a portion for housing a getter for absorbing or adsorbing impurities, a getter is housed in the getter housing portion, and at least part of the getter housing portion housing the getter is comprised by a metal fiber sintered sheet (16) having a plurality of holes which allow said impurities to pass through while do not allow the getter to pass through.

10. An optical device/electronic circuit housing device as set forth in claim 8 or 9, wherein said impurities include moisture and/or organic impurities; and
wherein said getter absorbs or adsorbs said moisture and/or organic impurities.

11. An optical device/electronic circuit housing device as set forth in any one of claims 8 to 10, wherein said getter contains any of porous silica gel, a zeolite-based hygroscopic agent/adsorbent, and a mixture of silica gel and a zeolite-based hygroscopic agent/adsorbent.

12. An optical device/electronic circuit housing device as set forth in any one of claims 8 to 11, wherein said metal fiber sintered sheet has a plurality of holes of a mean diameter of not more than 10 µm.

13. An optical device/electronic circuit housing device as set forth in any one of claims 8 to 12, wherein said metal fiber sintered sheet (16) is made of stainless steel.

14. An optical device/electronic circuit housing device as set forth in claim 13, wherein said metal fiber sintered sheet (16) is produced by
pressing a slurry containing stainless steel fiber and binder fiber to remove the water;
preparing a high metal fiber sheet by drying by heating the pressed substance; and
sintering the high metal fiber sheet.

15. An optical device/electronic circuit housing device as set forth in any one of claims 8 to 14, wherein said gas filled in the package (2) contains nitrogen.

16. An optical device/electronic circuit housing device as set forth in any one of claims 8 to 14, wherein said gas filled in the package (2) is nitrogen containing oxygen.

17. An optical device/electronic circuit housing device as set forth in claim 16, wherein a wavelength of light emitted from said semiconductor laser (3) is a short wavelength band.

18. An optical device/electronic circuit housing device as set forth in any one of claims 8 to 14, wherein said gas filled in the package (2) is only an inert gas.

19. An optical device/electronic circuit housing device as set forth in claim 19, wherein said inert gas filled in the package (2) is nitrogen.

20. An optical device/electronic circuit housing device as set forth in claim 18 or 19, wherein a wavelength of light emitted from said semiconductor laser (3) is a long wavelength band.

21. An optical device/electronic circuit housing device as set forth in any one of claims 8 to 20, wherein an electronic circuit is housed in said package (2).

22. An optical device/electronic circuit housing device as set forth in any one of claims 8 and 10 to 22, wherein:
portions other than said metal fiber sintered sheet (16) of said getter housing (10) is formed from Fe-Ni alloy, Fe-Ni-Co alloy, etc.;
said metal fiber sintered sheet (16) is fixed to said getter housing (10);
said package (2) is formed from the same metal as the portions other than said metal fiber sintered sheet (16) of said getter housing (10); and
said getter assembly is fixed to a predetermined internal portion of said package (2).

23. An optical device/electronic circuit housing device as set forth in any one of claims 9 to 22, wherein:
said package is formed from Fe-Ni alloy, Fe-Ni-Co alloy, etc.;
said stainless steel fiber sintered sheet (16) is fixed to said package; and
said metal fiber sintered sheet (16) is fixed to a getter housing portion of said package (2).

24. A housing device, comprising:
a package (2);
a gas containing an inert gas filled in the package; and
a getter assembly provided in said package or at a part of said package, comprised by a getter (18) for absorbing or adsorbing moisture and/or organic impurities and a getter housing (10) for housing the getter; and
wherein the getter housing is at least partially comprised by a metal fiber sintered sheet (16) having a plurality of holes which allow said impurities to pass through while do not allow the getter to pass through.

25. An optical device/electronic circuit housing device as set forth in claim 24, wherein said getter contains any of porous silica gel, a zeolite-based hygroscopic agent/adsorbent, and a mixture of silica gel and a zeolite-based hygroscopic agent/adsorbent.

26. An optical device/electronic circuit housing device as set forth in claim 24 or 25, wherein said metal fiber sintered sheet has a plurality of holes of a mean diameter of not more than 10 µm.

27. An optical device/electronic circuit housing device as set forth in any one of claims 24 to 26, wherein said metal fiber sintered sheet (16) is made of stainless steel.

28. An optical device/electronic circuit housing device as set forth in claim 27, wherein said metal fiber sintered sheet (16) is produced by
pressing a slurry containing stainless steel fiber and binder fiber to remove the water;
preparing a high metal fiber sheet by drying by heating the pressed substance; and
sintering the high metal fiber sheet.
